# EUROPÄISCHE PATENTSCHRIFT

(11) **EP 4 281 737 B1**
(45) Veröffentlichungstag und Bekanntmachung des Hinweises auf die Patenterteilung: **30.10.2024**
(21) Anmeldenummer: 21819744.0
(22) Anmeldetag: 22.11.2021
(51) Int. Cl.: G01K 1/14, G01K 1/18, G01K 7/18, G01K 7/22, H01R 13/04, H05K 1/18

(54) **ANORDNUNG MIT EINEM STIFTFÖRMIGEN ELEKTRISCHEN KONTAKTELEMENT UND EINER TEMPERATURMESSVORRICHTUNG ZUM MESSEN EINER TEMPERATUR DES STIFTFÖRMIGEN ELEKTRISCHEN KONTAKTELEMENTS**
ARRANGEMENT WITH A PIN-SHAPED ELECTRICAL CONTACT ELEMENT AND A TEMPERATURE MEASURING DEVICE FOR MEASURING A TEMPERATURE OF THE PIN-SHAPED ELECTRICAL CONTACT ELEMENT
ENSEMBLE COMPRENANT UN ÉLÉMENT DE CONTACT ÉLECTRIQUE EN FORME DE BROCHE ET UN DISPOSITIF DE MESURE DE LA TEMPÉRATURE POUR MESURER UNE TEMPÉRATURE DE L'ÉLÉMENT DE CONTACT ÉLECTRIQUE EN FORME DE BROCHE

(30) Priorität: 22.01.2021 DE 102021101349
(43) Veröffentlichungstag der Anmeldung: 29.11.2023
(73) Patentinhaber: Lisa Dräxlmaier GmbH, 84137 Vilsbiburg (DE)
(72) Erfinder: SCHAFFERHANS, Stephan, 81477 München (DE); MURGOTT, Krzysztof, 85716 Unterschleißheim (DE)
(86) Internationale Anmeldenummer: PCT/EP2021/082537
(87) Internationale Veröffentlichungsnummer: WO 2022/156938

(56) Entgegenhaltungen:
- CN-U- 208 171 458
- CN-U- 208 238 969
- DE-A1- 102018 120 057

## Beschreibung

Die vorliegende Erfindung betrifft eine Anordnung mit einer Temperaturmessvorrichtung.

Steigende Stromstärken im Bereich der Elektromobilität bringen viele Leitungs- und Stecksysteme an ihre thermischen Grenzen. Ein solches Stecksystem kann beispielsweise eine Mehrzahl von stiftförmigen elektrischen Kontaktelementen, insbesondere Kontaktpins einer Ladedose eines Elektrofahrzeugs, aufweisen. Schon leicht erhöhte Übergangswiderstände an Schraub- oder Steckkontakten können zu kritischen Temperaturen führen, welche durch geeignete Überwachungsmaßnahmen rechtzeitig erkannt werden sollten.

Infolge eines solchen Fehlerfalls kann beispielsweise die Ladeleistung oder die Antriebsleistung eines Elektrofahrzeugs reduziert werden, um die Überhitzung des Systems oder sogar einen Brand zu vermeiden.

Hierfür kann eine Temperaturüberwachung eingerichtet werden, die ein solches Stecksystem thermisch überwacht. Hierfür kann eine Temperaturmessvorrichtung vorgesehen werden. Je genauer die Temperatur des Stecksystems gemessen werden kann, desto schneller kann auf eine kritische Temperatur reagiert werden.

Eine Möglichkeit, die Temperatur an einem Kontaktelement zu messen ist eine Infrarotmessung. Andere Möglichkeiten umfassen beispielsweise wärmeleitende Elemente, die an der zylindrischen Fläche des Kontaktelements anliegen können.

Die DE 10 2018 120 057 A1 offenbart eine Temperaturmesseinrichtung für Steckverbinder, beinhaltend mindestens ein Trägerelement, mindestens ein Temperaturmessmittel samt Leiterbahnen sowie bedarfsweise mindestens ein aus Keramikmaterial bestehendes Deckelement, wobei das Temperaturmessmittel samt Leiterbahnen auf dem Trägerelement oder zwischen dem Trägerelement und dem bedarfsweisen Deckelement aufgebracht und zumindest mit einem der beiden Bauteile in Wirkverbindung steht, dergestalt, dass die Verbindung der Bauteile durch ein Glaslot erfolgt.

Die CN 208 171 458 U und die CN 208 238 969 U offenbaren jeweils ein Wärmeleitbauteil für einen Temperatursensor und einen Steckverbinder.

### Beschreibung der Erfindung

Die Aufgabe der Erfindung ist es, eine vorteilhafte Möglichkeit der Temperaturmessung aufzuzeigen.

Die Aufgabe wird durch den Gegenstand des unabhängigen Anspruchs gelöst. Insbesondere wird die Aufgabe durch eine Anordnung mit einem stiftförmigen Kontaktelement und einer Temperaturmessvorrichtung zum Messen einer Temperatur des stiftförmigen Kontaktelements gemäß dem unabhängigen Anspruch gelöst. Vorteilhafte Weiterbildungen der Erfindung sind in der Beschreibung und den begleitenden Figuren angegeben.

Die Temperaturmessvorrichtung umfasst eine flexible Leiterplatte mit einer ersten thermisch leitenden und elektrisch isolierenden Substratschicht mit einer Auflagefläche, die eingerichtet ist, an einem Flansch des stiftförmigen elektrischen Kontaktelements flächig aufzuliegen und einer in der Auflagefläche angeordneten Öffnung, wobei das stiftförmige Kontaktelement wenigstens teilweise in der Öffnung anordenbar ist; und einer zweiten thermisch und elektrisch leitenden Schicht, die auf einer der Auflagefläche gegenüberliegenden Sensorfläche der ersten Substratschicht angeordnet ist und ein mit der Sensorfläche verbundenes Sensorelement aufweist, das eingerichtet ist, eine Temperatur des stiftförmigen elektrischen Kontaktelements zu erfassen, wenn das stiftförmige elektrische Kontaktelement in der Öffnung wenigstens teilweise angeordnet ist.

Hierdurch wird eine hochdynamische und trotzdem elektrisch isolierte Temperaturmessung an dem stiftförmigen elektrischen Kontaktelement, insbesondere zylindrischen stiftförmigen elektrischen Kontaktelement, ermöglicht. Das stiftförmige elektrische Kontaktelement kann gesteckt oder geschraubt an einer Ladedose angeordnet sein. Die Wärme des Kontaktelements kann vom Kontaktelement über den Flansch und durch die Auflagefläche und die erste Schicht zu der Sensorfläche und der zweiten Schicht fließen.

Vorteile sind beispielsweise eine große Kontaktfläche zur Wärmeflussoptimierung, eine geringe thermische Masse zur Erhöhung der Messdynamik, eine gute elektrische Isolation, die bis in den höheren kV-Bereich skalierbar ist, eine hohe Robustheit gegenüber mechanischen Toleranzen und Schwingungen, sowie ein einfaches und automatisierbares Montagekonzept, um die Skalierbarkeit bei hohen Stückzahlen zu gewährleisten. Ein Abwägen von Messgenauigkeit und automatisierter Montierbarkeit gegeneinander kann so vermieden werden.

Die Temperaturmessvorrichtung stellt demnach einen Flachleiter mit einem Temperaturmesselement dar, die auf einem Flansch, d.h. einem Absatz, des stiftförmigen elektrischen Kontaktelements angeordnet sein kann. Insbesondere kann das stiftförmige elektrische Kontaktelement ein Leistungskontakt eines Ladesystems für (hybrid)elektrische Fahrzeuge (Ladedose bzw. Ladepistole) sein und mit der Temperaturmessvorrichtung kann die Temperatur des Leistungskontakts überwacht werden.

Das stiftförmige elektrische Kontaktelement weist den Flansch auf, durch welchen eine ebene Messfläche entsteht, auf welche die flexible Leiterplatte mit der Auflagefläche durch, insbesondere ein elastisches Anpresselement, andrückbar ist. Der Flansch kann speziell für diesen Zweck ausgeprägt sein, z.B. als umlaufender Tellerbereich eines zylindrischen Steckkontakts. Der Flansch kann ebenso eine anderweitig ausgeprägte ebene Fläche, welche insbesondere orthogonal zur Längsachse des zylindrischen Kontaktelements, d.h. des stiftförmigen elektrischen Kontaktelements, liegt, als Auflage- und Messfläche des Flachleiters genutzt werden. Hierfür kann beispielsweise ein angeschweißter Kabelschuh oder ein angeschraubter Kabelschuh oder eine angeschweißte Stromschiene oder eine angeschraubte Stromschiene in Frage kommen. Der Flansch ist insbesondere orthogonal gegenüber der Längsachse des stiftförmigen elektrischen Kontaktelements angeordnet und schafft so eine ausgerichtete Messfläche zur Messung der Temperatur. Hierdurch kann ein automatisierter Sandwichaufbau ermöglicht werden.

Die Temperaturmessvorrichtung ermöglicht eine elektrisch isolierte und thermisch hochdynamische Sensoranbindungen, und kann einen raschen Temperaturanstieg schnell und zuverlässig erkennen. Die Temperaturmessvorrichtung ist eine kostengünstige und automatisierbare Lösung und kann so den steigenden Stückzahlen im Bereich der Elektromobilität Rechnung tragen. Insbesondere kann zwischen stiftförmigen elektrischen Kontaktelement und der zweiten Schicht, welche insbesondere durch Laminieren oder Kleben auf die erste Schicht aufgebracht wird, die elektrische Isolation der innenliegenden Sensorfläche und Leiterbahnen gewährleistet sein.

Die flexible Leiterplatte kann ein Flachleiter, d.h. eine Flexplatine sein. Die flexible Leiterplatte kann ein flexibles, elektrisch isolierendes Substrat als erste Schicht aufweisen, welches eine Potentialtrennung zwischen dem stiftförmigen elektrischen Kontaktelement und dem Sensorelement bereitstellen kann. Das stiftförmige elektrische Kontaktelement kann beispielsweise einem elektrischen Potential zwischen ca. 400 V und 1000 V zugeordnet sein. Das Sensorelement kann insbesondere einem niedrigeren Potential, z.B. dem Niedervoltbordnetz eines Fahrzeugs, zugeordnet sein.

Die erste Substratschicht weist eine Öffnung auf, durch welche das stiftförmige elektrische Kontaktelement führbar ist. Insbesondere ist die Öffnung ein Loch und das stiftförmige elektrische Kontaktelement kann durch die Öffnung gesteckt werden. Dabei weist die erste Substratschicht eine Auflagefläche und eine der Auflagefläche gegenüberliegende Sensorfläche auf.

Die Auflagefläche ist thermisch an das stiftförmige elektrische Kontaktelement anbindbar, d.h. die erste Substratschicht kann mit der Auflagefläche direkt auf dem stiftförmigen elektrischen Kontaktelement aufliegen. Auch kann zwischen dem stiftförmigen elektrischen Kontaktelement und der Auflagefläche eine wärmeleitende Schicht eingebracht sein, durch die die Auflagefläche an das stiftförmige elektrische Kontaktelement angebunden ist. Die Sensorfläche des Flachleiters kann so ausgeprägt sein, dass sie die Auflagefläche auf dem Absatz des Kontaktelements widerspiegelt und somit eine maximale Wärmedurchflussfläche nutzt.

Die wärmeleitende Schicht kann beispielsweise Grafit oder einen metallischen Werkstoff umfassen und dient der Wärmespreizung, um die Wärmedurchflussfläche zu vergrößern. Die wärmeleitende Schicht kann sehr dünn ausgeführt sein, insbesondere dünner als 1 mm, um die zusätzliche thermische Masse im Messpfad zu minimieren. Die wärmeleitende Schicht kann dabei mit der ersten Substratschicht, d.h. dem flexiblen Substrat, verbunden sein, insbesondere an der Auflagefläche auflaminiert oder aufgeklebt sein, oder fest an dem stiftförmigen elektrischen Kontaktelement angebracht sein, beispielsweise geklebt, gelötet oder geschweißt sein, oder eine eigenständige Komponente sein, insbesondere eine auflegbare Scheibe.

In einer Ausgestaltung ist die Auflagefläche geometrisch an den Flansch des stiftförmigen elektrischen Kontaktelements angepasst.

Hierbei kann die Auflagefläche so gestaltet sein, dass eine möglichst große Fläche auf dem Flansch des stiftförmigen elektrischen Kontaktelements aufliegt. Darüber hinaus kann die Geometrie der flexiblen Leiterplatte so gestaltet sein, dass diese leichte Bewegungen des stiftförmigen elektrischen Kontaktelements, beispielsweise verursacht durch die Montage, geometrische Toleranzen oder Erschütterungen, ausgleichen kann, ohne dabei die zweite thermisch und elektrisch leitende Schicht, die Sensorfläche oder den ggfs. aufgelöteten SMD-Sensor zu beschädigen.

In einer Ausgestaltung umfasst das Sensorelement eine flächige Leiterbahn, die auf der Sensorfläche angeordnet ist und einen Sensor, d.h. insbesondere einen Temperaturfühler, umfasst, der thermisch mit der flächigen Leiterbahn verbunden ist.

Dadurch wird der Temperaturfühler, d.h. der Temperatursensor sehr nah an das stiftförmige elektrische Kontaktelement gebracht, sodass ein geringer Verlust bei der Wärmeübertragung zu dem Temperaturfühler hin gewährleistet werden kann. Hierbei umfasst die Sensorfläche den Temperaturfühler selbst. Die Sensorfläche kann hierbei als Erweiterung einer Leitbahn ausgeführt sein, welche die Wärme in den aufgelöteten Temperatursensor leitet.

In einer Ausgestaltung weist die Sensorfläche ein Material mit einem temperaturabhängigen Widerstand auf.

Die Sensorfläche kann mit einem Material versehen werden, welches einen temperaturabhängigen elektrischen Widerstand aufweist, insbesondere einen möglichst starken temperaturabhängigen elektrischen Widerstand. Hierfür eignen sich insbesondere Platin oder Nickel. Beispielsweise kann ein Platindraht auf die Sensorfläche auf die erste Substratschicht auflaminiert oder aufgeklebt werden. Das Material, das den temperaturabhängigen elektrischen Widerstand aufweist kann das Sensorelement darstellen. Das Sensorelement kann außerhalb der Sensorfläche mit einer elektrischen Leitung verbunden sein. Hierbei kann mit einer dritten elektrisch isolierenden Schicht eine vollständige elektrische Isolation der Temperaturmessvorrichtung erfolgen, da das Sensorelement nicht durch die Isolation hindurchragt. Der Aufbau wird auch flacher.

In einer Ausgestaltung umfasst die Sensorfläche einen mäanderförmig angeordneten Metalldraht. Hierbei kann die Sensorfläche weitmöglichst ausgenutzt werden.

In einer Ausgestaltung ist der mäanderförmig angeordnete Metalldraht in einem niederinduktiven Layout angeordnet.

Hierdurch kann eine Einkopplung elektromagnetischer Felder durch den im stiftförmigen elektrischen Kontaktelement fließenden Strom in die Sensorbahn verringert, insbesondere minimiert, werden.

In einer Ausgestaltung umfasst die Sensorfläche eine strukturierte Metallfolie. Die strukturierte Metallfolie kann insbesondere eine Platin- oder Nickelfolie sein, welche beispielsweise über Laser- oder Ätzprozesse strukturiert wird. Die Struktur kann hierbei den gleichen Maßstäben genügen, wie zu dem mäanderförmigen Metalldraht beschrieben.

In einer Ausgestaltung umfasst die Temperaturmessvorrichtung eine dritte isolierende Schicht auf der zweiten Schicht.

Hierbei kann eine Kriechstrecke des elektrischen Stroms von dem stiftförmigen elektrischen Kontaktelement, d.h. dem Hochvoltbereich, hin zu dem Sensorelement, d.h. dem Niedervoltbereich, erhöht werden. Das hießt, es kann Luft- und/oder Kriechstrecken für die elektrische Isolation der Potentiale des Sensorelements und/oder des stiftförmigen elektrischen Kontaktelements Rechnung getragen werden. Somit kann eine zusätzliche Isolationsschicht auf der Sensorfläche vorgesehen sein. Diese kann beispielsweise durch Kleben oder Laminieren einer dritten flexiblen isolierenden Substratschicht realisiert werden.

Die strukturierte Metallfolie kann mit einem Sensor, insbesondere einem SMD-Sensor, verbunden sein. Hierbei kann die dritte Substratschicht an der Position des Sensors eine Öffnung aufweisen, durch welche der Sensor im Fertigungsprozess aufgelötet werden kann. Um die elektrische Isolation auch an diesem Bauteil zu realisieren, kann der Sensor mit einer Glob Top Vergussmasse bedeckt werden. So kann der Sensor elektrisch isoliert werden.

Wenn die Sensorfläche direkt als Platin- oder Nickelbahn ausgeführt ist, d.h. insbesondere als mäanderförmig angeordneter Metalldraht, kann die bedeckende dritte Substratschicht ohne weitere Öffnungen aufgebracht werden um die gesamte Sensorfläche und ggf. auch angrenzende Bereiche der flexiblen Leiterplatte elektrisch zu isolieren. Die Öffnung, in der das stiftförmige Kontaktelement wenigstens teilweise anordenbar ist, ist in jeder der Substratschichten ausgebildet.

In einer Ausgestaltung umfasst die zweite Schicht wenigstens eine elektrische Leitung, die eingerichtet ist, die Temperaturmessvorrichtung elektronisch mit einer Auswerteeinheit zu verbinden. Die elektrische Leitung kann eine Möglichkeit zur elektrischen Kontaktierung und eine Signalleitung bereitstellen.

Hierbei wird weitere Peripherie in die flexible Leiterplatte eingebunden und zusätzliche Kabel oder Leitungen, die Platz benötigen, können vermieden werden. Von der Sensorfläche bzw. dem Sensor, insbesondere dem SMD-Sensor, führen Leiterbahnen weg zu einer Auswerteeinheit, welche entweder auf dem flexiblen Substrat mit aufgebracht sein kann oder aber durch eine Steck-, Löt-, Schweiß- oder Crimpverbindung mit den Leiterbahnen elektrisch direkt oder indirekt, beispielsweise über ein weiteres Kabel, verbunden ist.

Erfindungsgemäß wird die Aufgabe durch eine Anordnung mit einem stiftförmigen Kontaktelement und einer Temperaturmessvorrichtung zum Messen einer Temperatur des stiftförmigen Kontaktelements gemäß dem unabhängigen Anspruch gelöst.

Die Anordnung umfasst ein Gehäuse mit einem ersten Gehäuseteil und einem zweiten Gehäuseteil, wobei der Flansch des stiftförmigen elektrischen Kontaktelements an dem ersten Gehäuseteil anliegt und wobei das zweite Gehäuseteil eine Kraft auf die flexible Leiterplatte in Richtung der ersten Gehäuseteils ausübt und die Auflagefläche der flexiblen Leiterplatte so gegen den Flansch des stiftförmigen elektrischen Kontaktelements drückt. Hierbei kann die Temperaturmessvorrichtung sicher fixiert werden.

Zwischen der flexiblen Leiterplatte und dem zweiten Gehäuseteil ist ein elastisches Anpresselement angeordnet. Hierbei wird der Druck über das elastische Anpresselement auf die flexible Leiterplatte ausgeübt.

Das elastische Anpresselement, beispielsweise eine Dichtung wie ein O-Ring, kann dazu dienen, die flexible Leiterplatte auf den Flansch des Kontaktelements zu drücken. Die elastische Eigenschaft kann dazu dienen, dass auch bei thermischer Ausdehnung des stiftförmigen elektrischen Kontaktelements oder einem mechanischen Spiel in einer Verankerung des stiftförmigen elektrischen Kontaktelements immer ein ausreichender Anpressdruck auf die flexible Leiterplatte herrscht. Dadurch soll die flexible Leiterplatte mit ihrem Kontaktbereich, d.h. der Auflagefläche, möglichst großflächig und ohne Luftspalt auf dem stiftförmigen elektrischen Kontaktelement aufliegen um den Wärmefluss vom stiftförmigen elektrischen Kontaktelement zu der Sensorfläche der flexiblen Leiterplatte unter allen Umgebungsbedingungen zu gewährleisten, insbesondere zu verbessern, weiter insbesondere zu maximieren. Im Anwendungsfall einer Ladedose kann das elastische Anpresselement durch eine Dichtung des stiftförmigen elektrischen Kontaktelements realisiert sein. Hierfür wird die Dichtung so weit entlang des stiftförmigen elektrischen Kontaktelements verlängert, dass sie im fertig montierten Zustand durch einen leichten Überstand gegenüber dem Flansch des Kontaktelements den dazwischenliegenden Flachleiter auf den Flansch des Kontaktelements presst.

Zwischen dem Flansch des stiftförmigen elektrischen Kontaktelements und dem ersten Gehäuseteil ist ein weiteres elastisches Anpresselement angeordnet. Dies kann eine weitere Flexibilität bringen und trotzdem einen sicheren anpressdruck der Temperaturmessvorrichtung auf den Flansch gewährleisten.

Nicht erfindungsgemäß ist ein Verfahren zum Herstellen einer Temperaturmessvorrichtung zum Messen einer Temperatur eines stiftförmigen elektrischen Kontaktelements, umfassend ein Bereitstellen einer ersten thermisch leitenden und elektrisch isolierenden Substratschicht einer flexiblen Leiterplatte mit einer Auflagefläche, die eingerichtet ist, an einem Flansch des stiftförmigen elektrischen Kontaktelements flächig aufzuliegen und einer in der Auflagefläche angeordneten Öffnung, wobei das stiftförmige Kontaktelement wenigstens teilweise in der Öffnung anordenbar ist; und ein Aufbringen einer zweiten thermisch und elektrisch leitenden Schicht auf die bereitgestellte erste Substratschicht, aufweisend ein auf einer der Auflagefläche gegenüberliegenden Sensorfläche der ersten Substratschicht angeordnetes Sensorelement, das eingerichtet ist, eine Temperatur des stiftförmigen elektrischen Kontaktelements an der Auflagefläche zu erfassen, wenn das stiftförmigen elektrischen Kontaktelements in der Öffnung wenigstens teilweise angeordnet ist.

In einer Ausgestaltung umfasst das Verfahren ein Aufbringen einer dritten isolierenden Schicht auf die zweiten Schicht.

### Kurze Figurenbeschreibung

Nachfolgend wird die Erfindung anhand von Ausführungsbeispielen und Figuren erläutert. Es zeigen:
- Fig. 1a: eine nicht erfindungsgemäße Temperaturmessvorrichtung gemäß einem Ausführungsbeispiel,
- Fig. 1b: eine Anordnung mit der Temperaturmessvorrichtung gemäß dem Ausführungsbeispiel von Fig. 1a,
- Fig. 2a: eine nicht erfindungsgemäße Temperaturmessvorrichtung gemäß einem weiteren Ausführungsbeispiel,
- Fig. 2b: eine Anordnung mit der Temperaturmessvorrichtung gemäß dem Ausführungsbeispiel von Fig. 2a
- Fig. 3a: eine perspektivische Explosionsdarstellung der Anordnung aus Fig. 1b,
- Fig. 3b: eine weitere perspektivische Explosionsdarstellung der Anordnung aus Fig. 1b,
- Fig. 3c: eine weitere perspektivische Explosionsdarstellung der Anordnung aus Fig. 1b,
- Fig. 4a: eine perspektivische Explosionsdarstellung der Anordnung aus Fig. 2b,
- Fig. 4b: eine weitere perspektivische Explosionsdarstellung der Anordnung aus Fig. 2b,
- Fig. 4c: eine weitere perspektivische Explosionsdarstellung der Anordnung aus Fig. 2b,
- Fig. 5a: eine Anordnung mit einer Temperaturmessvorrichtung gemäß einem Ausführungsbeispiel in einer ersten Lage,
- Fig. 5b: die Anordnung gemäß Fig. 5a in einer zweiten Lage, und
- Fig. 6: ein Flussdiagramm für ein nicht erfindungsgemäßes Verfahren gemäß einem Ausführungsbeispiel.

Die Figuren sind lediglich schematische Darstellungen und dienen der Erläuterung der Erfindung. Gleiche oder gleichwirkende Elemente sind mit den gleichen Bezugszeichen versehen. Zum leichteren Verständnis werden in der folgenden Beschreibung die Bezugszeichen zu den Figuren als Referenz beibehalten.

### Detaillierte Beschreibung

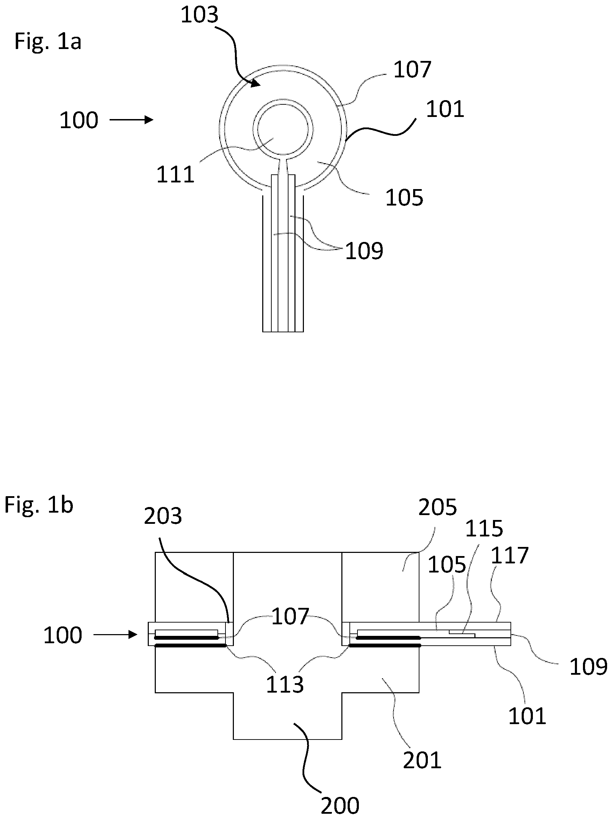

Fig. 1a zeigt eine Temperaturmessvorrichtung 100 gemäß einem Ausführungsbeispiel. Die Temperaturmessvorrichtung 100 weist eine erste thermisch leitende und elektrisch isolierende Substratschicht 101 auf. Die erste Substratschicht 101 ist eine außenliegende Schicht einer flexiblen Leiterplatte.

Auf der ersten Substratschicht 101 ist eine zweite thermisch und elektrisch leitende Schicht 103 aufgebracht. Die zweite Schicht 103 umfasst ein Sensorelement 105. Das Sensorelement 105 ist als Leiterbahn ausgestaltet, insbesondere aus Platin- oder Nickel. Hierbei ist das Sensorelement 105 als Metalldraht ausgeführt, der mäanderartig auf einer Sensorfläche 107 aufgebracht ist, in Fig. 1 aus Gründen der Übersichtlichkeit jedoch lediglich als Fläche dargestellt. In einem weiteren Ausführungsbeispiel ist das Sensorelement 105 eine Folie. Das Sensorelement 105 weist ein Material mit einem temperaturabhängigen Widerstand auf.

Auf der ersten Substratschicht 101 ist des Weiteren eine elektrische Leitung 109 angeordnet, insbesondere umfasst die elektrische Leitung 109 zwei Leiterbahnen. Die elektrische Leitung 109 bildet eine elektrische Kontaktierung des Sensorelements 105 und dient als Signalleitung. Über die elektrische Leitung 109 wird der Widerstand des Sensorelements 105 von einer Auswerteeinheit, die in den Figuren aus Gründen der Übersichtlichkeit nicht dargestellt ist, gemessen.

Die Temperaturmessvorrichtung 100 weist eine Öffnung 111 auf. Die Öffnung 111 ist hierbei ein Loch. In einem weiteren Ausführungsbeispiel kann die Öffnung 111 so angeordnet sein, dass die Sensorfläche 107 u-förmig ist. Das heißt, die Öffnung 111 kann eine Einkerbung in der Temperaturmessvorrichtung 100 sein.

Fig. 1b zeigt eine Anordnung der Temperaturmessvorrichtung 100 gemäß dem Ausführungsbeispiel aus Fig. 1a und einem stiftförmigen elektrischen Kontaktelement 200. In Fig. 1b ist lediglich ein Ausschnitt des Kontaktelements 200 dargestellt, insbesondere erstreckt sich das Kontaktelement 200 senkrecht zu der Temperaturmessvorrichtung 100 weiter als in der Fig. 1b dargestellt. Das Kontaktelement 200 weist einen Flansch 201 auf.

Die Temperaturmessvorrichtung 100 weist eine Auflagefläche 113 auf. Die Temperaturmessvorrichtung 100 liegt mit der Auflagefläche 113 flächig auf dem Flansch 201 auf. Hierdurch ergibt sich eine große Kontaktfläche zwischen dem Kontaktelement 200 und der Temperaturmessvorrichtung 100, über die Wärme von dem Kontaktelement 200 zu der Temperaturmessvorrichtung 100 geführt werden kann, d.h. über die Wärme von dem Kontaktelement 200 das Sensorelement 105 der Temperaturmessvorrichtung 100 erwärmen kann. Da die erste Substratschicht 101 dünn ist, ist hierbei der Wärmeverlust gering.

Die Öffnung 111 der Temperaturmessvorrichtung 100 ist an eine Außenkontur des stiftförmigen elektrischen Kontaktelements 200 angepasst, sodass zwar ein Spalt 203 zwischen Kontaktelement 200 und Temperaturmessvorrichtung 100 zum Ausgleich von Toleranzen und Bewegungen entsteht, der Spalt 203 jedoch gleichzeitig so klein bleibt, dass die Oberfläche des Flansches 201 von der Auflagefläche 113 zu einem möglichst großen Teil bedeckt werden kann.

In Fig. 1b ist zwischen dem Sensorelement 105 und der elektrischen Leitung 109 ein Übergang 115 zu sehen, an dem das Sensorelement 105 und die elektrische Leitung 109 miteinander verbunden sind. Hierbei sind die beiden unterschiedlichen Materialien miteinander verlötet. In einem weiteren Ausführungsbeispiel handelt es sich um die gleichen Materialien und/oder es wird eine andere Art der Verbindung gewählt als Löten.

In Fig. 1b ist des Weiteren eine dritte isolierende Schicht 117 dargestellt. Die dritte isolierende Schicht 117 ist auf der zweiten Schicht 103 aufgebracht. Die dritte isolierende Schicht 117 schützt die zweite Schicht 103 vor Umwelteinflüssen und stellt eine elektrische Isolierung sowohl des Sensorelements 105, als auch der elektrischen Leitung 109 dar. In einem weiteren Ausführungsbeispiel kann diese dritte Schicht entfallen und die elektrische Isolierung kann durch ein elastisches Anpresselement 205, d.h. ein aufpressbares Element, erfolgen, beispielsweise eine Dichtung. Die zweite Schicht 103 wird an der Auflagefläche 113 von der dritten isolierenden Schicht 117 vollständig bedeckt. In einem weiteren Ausführungsbeispiel bedeckt die dritte isolierende Schicht 117 die zweite Schicht 103 lediglich teilweise.

Die Sensorfläche 107 ist so groß gewählt, das ein Rand an der ersten Substratschicht 101 über die zweite Schicht 103 übersteht, sodass eine Verklebung der ersten Substratschicht 101 mit der dritte isolierende Schicht 117 möglich ist, um die elektrische Isolierung der zweiten Schicht 103 zu gewährleisten. Insbesondere beträgt der Rand wenigstens 100µm für das Verkleben. Ein Rand von 1 mm bis 2 mm kann nach dem Verkleben der ersten Substratschicht 101 mit der dritten isolierenden Schicht 117 eine größere horizontale Isolation bzw. eine größere Kriechstrecke bieten. In einem weiteren Ausführungsbeispiel wird statt einem Verkleben ein Verschweißen der ersten Substratschicht 101 mit der dritten isolierenden Schicht 117 verwendet. Die Verbindung der ersten Substratschicht 101 mit der dritten isolierenden Schicht 117 kann insbesondere 130 Grad Celsius aushalten, um ein Lösen im Betrieb zu vermeiden.

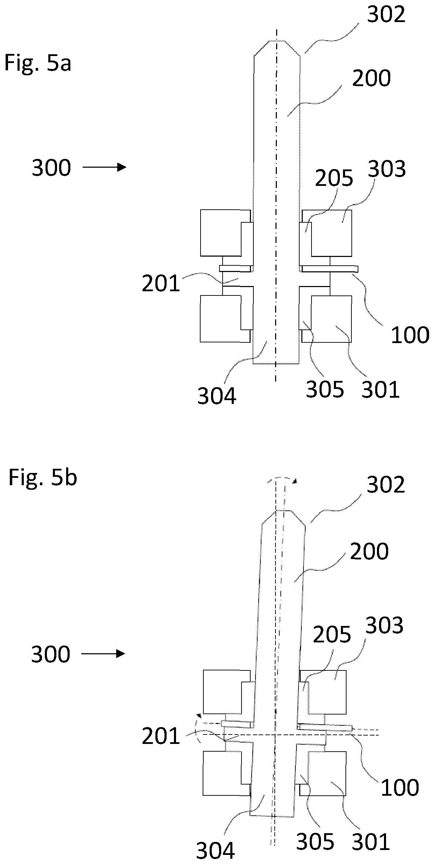

In Fig. 1b ist ein elastisches Anpresselement 205 dargestellt, das zusätzlich zu der dritten isolierenden Schicht 117 verwendet wird. Das elastische Anpresselement 205 ist ein elastisches Element, beispielsweise eine Dichtung, das auf die Temperaturmessvorrichtung 100 pressbar ist, um die Temperaturmessvorrichtung 100 in Position zu halten. Dies wird zu den Fig. 5a und 5b genauer beschrieben.

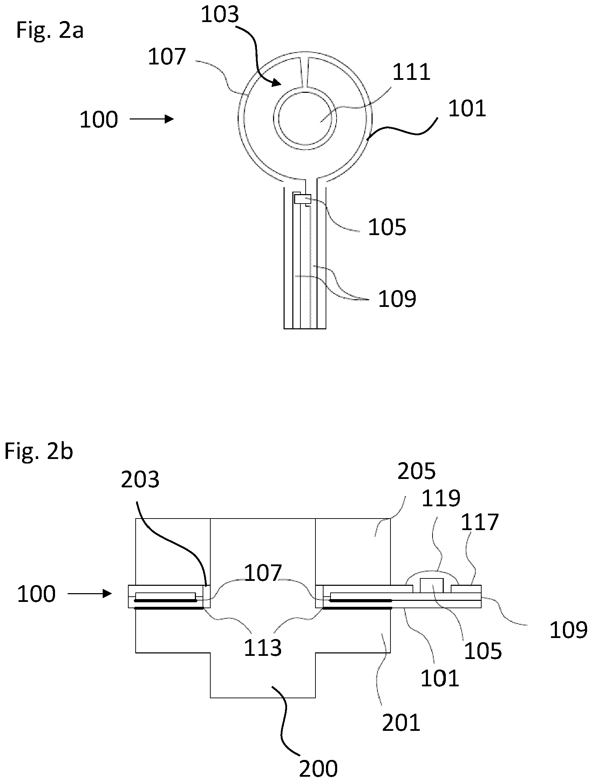

In Fig. 2a ist eine Temperaturmessvorrichtung 100 gemäß einem weiteren Ausführungsbeispiel dargestellt. Wie zu dem Ausführungsbeispiel von Fig. 1a beschrieben, weist die Temperaturmessvorrichtung 100 gemäß Fig. 2a eine erste Substratschicht 101, eine Sensorfläche 107, und eine zweite Schicht 103 auf. Das Sensorelement 105 ist jedoch als SMD-Temperaturfühler, insbesondere als PT1000 oder NTC, ausgeführt. Die Sensorfläche 105 ist hierbei als Leitbahn ausgeführt, welche die Wärme in das Sensorelement 105, d.h. hier den aufgelöteten Temperatursensor, leitet. Wie zu Fig. 1a beschrieben kann das Sensorelement 105 über die elektrische Leitung 109 ausgelesen werden. Die Öffnung 111 ist gleichermaßen wie zu Fig. 1a beschrieben ausgestaltet.

Fig. 2b zeigt eine Anordnung, wie zu Fig. 1b beschrieben, wobei jedoch als Temperaturmessvorrichtung 100 die Temperaturmessvorrichtung 100 gemäß dem Ausführungsbeispiel von Fig. 2a verwendet wird, bei der das Sensorelement 105 einen SMD-Temperaturfühler umfasst.

Das Sensorelement 105 der Temperaturmessvorrichtung 100 gemäß dem Ausführungsbeispiel zu den Fig. 2a und 2b weist in der dritten isolierenden Schicht 117 im Bereich des Sensorelements 105 eine Unterbrechung auf, sodass das Sensorelement 105 direkt auf der zweiten Schicht 103 angeordnet, insbesondere aufgelötet, sein kann. Die Unterbrechung in der dritten isolierenden Schicht 117 und das Sensorelement 105 sind hierbei mit einer Vergussmasse 119, insbesondere einer Glob Top Vergussmasse, bedeckt und so elektrisch isoliert und gegen Umwelteinflüsse geschützt.

In die Öffnung 111 ist in allen Ausführungsbeispielen ein stiftförmiges elektrisches Kontaktelement anordenbar, dessen Temperatur gemessen werden soll.

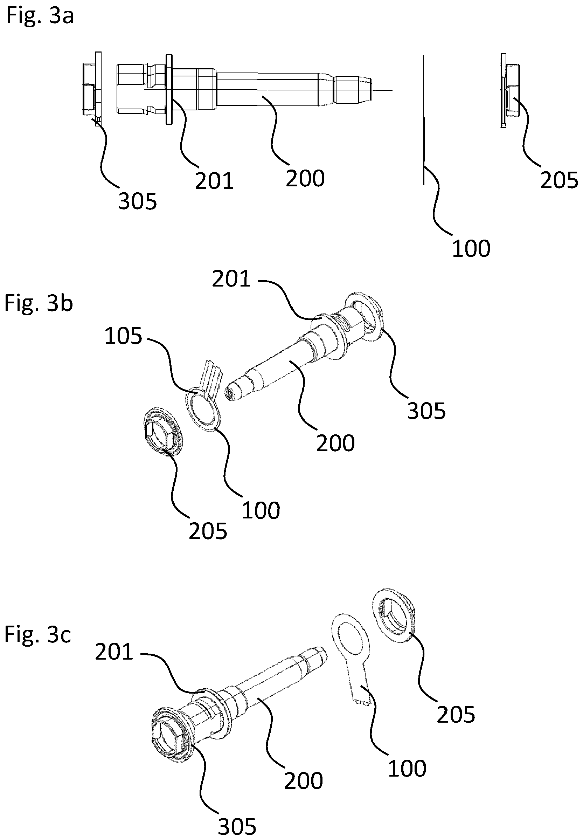

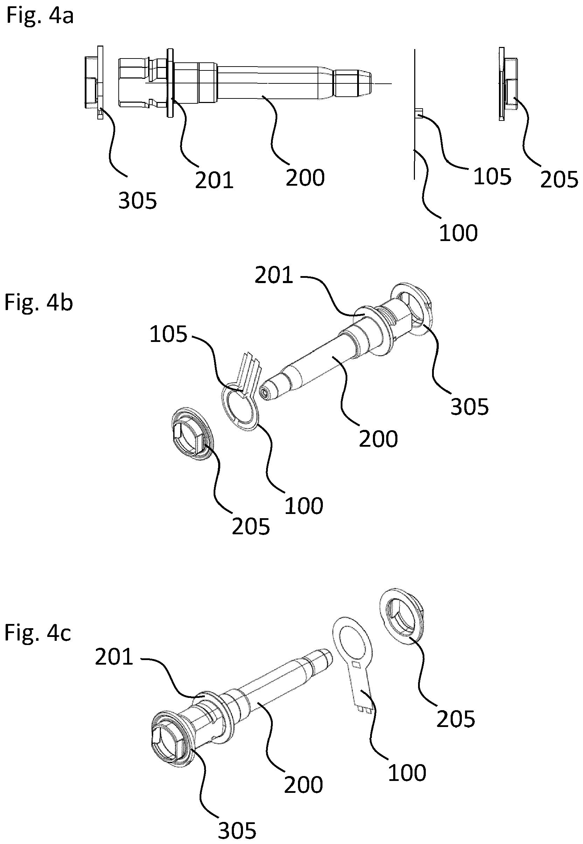

Die Fig. 3a bis 3c zeigen Explosionsdarstellungen der Anordnung gemäß den Fig. 1a und 1b. Die Fig. 4a bis 4c zeigen Explosionsdarstellungen der Anordnung gemäß den Fig. 12a und 2b. Hierbei sind die einzelnen Komponenten in axialer Richtung des elektrischen stiftförmigen Kontaktelements 200 auseinandergezogen.

Die Fig. 5a und 5b zeigen jeweils eine Schnittdarstellung einer Anordnung 300 mit einer Temperaturmessvorrichtung 100. Die Temperaturmessvorrichtung 100 ist schematisch dargestellt und kann einem der oben beschriebenen Ausführungsbeispiele entsprechen oder auch abgewandelt sein. Insbesondere wird eine Schnittansicht entlang der Längsachse des Kontaktelements 200 dargestellt.

Wie zu den Fig. 1b und 2b oben beschrieben weist die Anordnung 300 ein Kontaktelement 200, die Temperaturmessvorrichtung 100 und ein elastisches Anpresselement 205 auf. Das Kontaktelement 200, insbesondere einer Ladedose, umfasst einen äußeren Steckbereich 302 zur elektrischen Kontaktierung mit einer Ladepistole. Das Kontaktelement 200 umfasst einen fahrzeuginneren Abgangsbereich 304, an welcher ein Hochvoltkabelsatz angehängt ist.

Zusätzlich sind ein erstes Gehäuseteil 301 und zweites Gehäuseteil 303 dargestellt. Der Flansch 201 des stiftförmigen elektrischen Kontaktelements 200 liegt an dem ersten Gehäuseteil 301 an. Das zweite Gehäuseteil 303 übt eine Kraft auf die flexible Leiterplatte 101 in Richtung des ersten Gehäuseteils 301 aus. Das zweite Gehäuseteil 303 liegt hierbei mittels dem elastisches Anpresselement 205 auf der Temperaturmessvorrichtung 100 an und drückt die Temperaturmessvorrichtung 100 mit der Auflagefläche 113 gegen den Flansch 201.

Zwischen dem ersten Gehäuseteil 301 und der Auflagefläche 113 ist ein weiteres elastisches Anpresselement 305 angeordnet. In einem weiteren Ausführungsbeispiel umfasst die Anordnung 300 lediglich eines der beiden elastischen Anpresselemente 205, 305 oder keines und das erste Gehäuseteil 301 liegt direkt an dem Flansch 201 an bzw. das zweite Gehäuseteil 303 liegt direkt an der flexiblen Leiterplatte 101 an, insbesondere auf der dritten isolierenden Schicht 117.

In Fig. 5a ist das Kontaktelement 200 in einer normalen Position. Das heißt, es wirkt keine seitliche Kraft auf das Kontaktelement 200, d.h. es wirkt keine Kraft senkrecht zur Haupterstreckungsrichtung des stiftförmigen Kontaktelements 200. Beispielsweise bei einem Aufstecken eines Ladesteckers, in den Fig. nicht dargestellt, kann es jedoch zu Verkantungen oder anderen Beeinträchtigungen kommen, die eine seitliche Kraft auf das Kontaktelement 200 ausüben.

Ein solcher Fall ist schematisch in Fig. 5b dargestellt. Hierbei wirkt auf das Kontaktelement 200 eine seitliche Kraft, die in einer im Vergleich zur Ausrichtung gemäß Fig. 5a verdrehten Ausrichtung des Kontaktelements 200 resultiert, siehe Pfeile in Fig. 5a und 5b.

Die elastischen Anpresselemente 205, 305 stellen hierbei eine flexible Lagerung des Kontaktelements 200 dar. Das erste Gehäuseteil 301 und das zweite Gehäuseteil 303 fassen die Temperaturmessvorrichtung 100, d.h. den Messaufbau, ein.

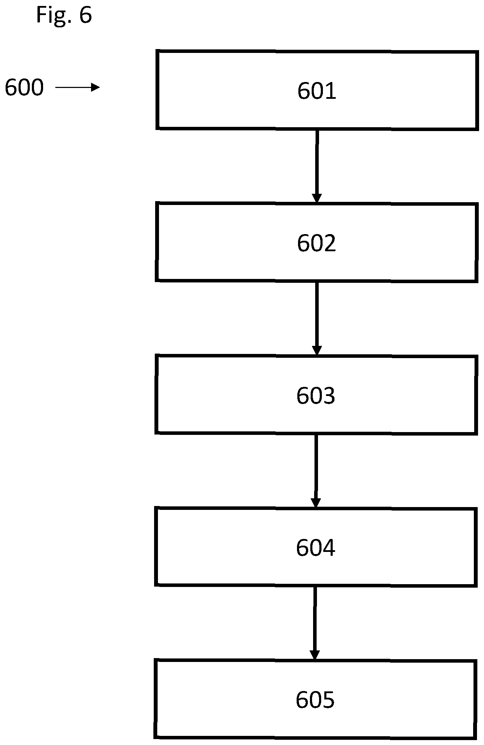

Fig. 6 zeigt ein Flussdiagramm 600 für ein Verfahren zum Herstellen einer Temperaturmessvorrichtung 100 gemäß einem Ausführungsbeispiel.

In einem Schritt 601 wird die erste thermisch leitende und elektrisch isolierende Substratschicht 101 bereitgestellt. Die erste Substratschicht 101 weist eine Auflagefläche 113 auf, die eingerichtet ist, an einem Flansch 201 des stiftförmigen elektrischen Kontaktelements 200 flächig aufzuliegen. Die Auflagefläche 113 weist die Öffnung 111 auf, wobei das stiftförmige Kontaktelement 200 wenigstens teilweise in der Öffnung 111 anordenbar ist.

In einem folgenden Schritt 602 wird die zweite thermisch und elektrisch leitende Schicht 103 auf die bereitgestellte erste Substratschicht 101 aufgebracht. Die zweite Schicht 103 weist ein auf der der Auflagefläche 113 gegenüberliegendes Sensorelement 105 auf, das auf der Sensorfläche 107 der ersten Substratschicht 101 angeordnet ist. In einem weiteren Ausführungsbeispiel wird das Sensorelement 105 nach dem Aufbringen der zweiten Schicht 103 auf die erste Substratschicht 101 aufgebracht.

In einem Schritt 603 wird die dritte isolierenden Schicht 117 auf die zweiten Schicht 103 aufgebracht. Hierbei wird die dritte isolierende Schicht 117 mit der ersten Substratschicht 101 an dem Rand um die zweite Schicht 103 herum verklebt. In einem weiteren Ausführungsbeispiel werden die dritte isolierende Schicht 117 und die erste Substratschicht 101 anders miteinander verbunden. In einem alternativen Ausführungsbeispiel wird auf die dritte isolierende Schicht 117 verzichtet. Hierbei kann ein elastisches Anpresselement 205 direkt auf der zweiten Schicht 103 aufliegen und neben einem Anpressen auch die elektrische Isolierung mitübernehmen.

In einem Schritt 604 wird die Temperaturmessvorrichtung 100 auf einem stiftförmigen elektrischen Kontaktelement 200 angeordnet. Hierbei kann die Temperaturmessvorrichtung 100 auf das Kontaktelement 200 aufgesteckt oder aber auch das Kontaktelement 200 in die Öffnung 111 der Temperaturmessvorrichtung 100 eingeführt werden. Hierbei liegt dann die Temperaturmessvorrichtung 100 mit der Auflagefläche 113 auf dem Flansch 201 des Kontaktelements 200 an, wie oben insbesondere zu den Fig. 1b, 2b, 5a und 5b beschrieben.

In einem Schritt 605 werden wird die in Schritt 604 erstellte Anordnung in ein Gehäuse mit dem ersten Gehäuseteil 301 und dem zweiten Gehäuseteil 303 angeordnet. Hierbei werden das elastische Anpresselement 205 und das weiteres elastische Anpresselement 305 zwischengelegt. In einem weiteren Ausführungsbespiel entfällt im Schritt 605 das Zwischenlegen eines oder beider elastischen Anpresselemente 205, 305.

Eine Montage kann automatisiert erfolgen. Hierbei können folgende Schritte durchgeführt werden. Einführen des Kontaktelements 200 in den ersten Gehäuseteil 301, gegebenenfalls mit bereits eingelegtem weiteren elastischen Anpresselement 305. Einlegen eines zusätzlichen Wärmeleitelements, beispielsweise einer Grafitscheibe auf das weitere elastische Anpresselement 305. Es folgt ein Auflegen der ersten Schicht 101 auf den Flansch 201 des Kontaktelements 200. Es wird eine Verbindung der elektrischen Leitung 109 der zweiten Schicht 103 mit der Auswerteeinheit oder einem Stecker oder einem anderen Kontaktsystem hergestellt. Dann kann ein Aufschieben des elastischen Anpresselements, d.h. der Dichtung, und des zweiten Gehäuseteils 303 erfolgen, um die Temperaturmessvorrichtung 100 auf den Flansch 201 des Kontaktelements 200 zu drücken.

In einem weiteren Ausführungsbeispiel kann einer der Schritte des Einlegens eines zusätzlichen Wärmeleitelements oder des Herstellens einer Verbindung der elektrischen Leitung 109 der zweiten Schicht 103 mit der Auswerteeinheit oder auch beide Schritte entfallen.

### BEZUGSZEICHENLISTE

- 100: Temperaturmessvorrichtung
- 101: erste Substratschicht
- 103: zweite Schicht
- 105: Sensorelement
- 107: Sensorfläche
- 109: elektrische Leitung
- 111: Öffnung
- 113: Auflagefläche
- 115: Übergang
- 117: dritte isolierende Schicht
- 119: Vergussmasse
- 200: Kontaktelement
- 201: Flansch
- 203: Spalt
- 205: elastisches Anpresselement
- 300: Anordnung
- 301: erstes Gehäuseteil
- 302: äußerer Steckbereich
- 303: zweites Gehäuseteil
- 304: fahrzeuginnerer Abgangsbereich
- 305: weiteres elastisches Anpresselement
- 600: Flussdiagramm
- 601 -605: Verfahrensschritt

## Patentansprüche

1. Anordnung (300) mit einem stiftförmigen Kontaktelement (200) und einer Temperaturmessvorrichtung (100) zum Messen einer Temperatur des stiftförmigen elektrischen Kontaktelements (200), die Temperaturmesseinrichtung (100) umfassend eine flexible Leiterplatte mit einer ersten thermisch leitenden und elektrisch isolierenden Substratschicht (101) mit einer Auflagefläche (113), die eingerichtet ist, an einem Flansch (201) des stiftförmigen elektrischen Kontaktelements (200) flächig aufzuliegen und einer in der Auflagefläche (113) angeordneten Öffnung (111), wobei das stiftförmige Kontaktelement (200) wenigstens teilweise in der Öffnung (111) angeordnet ist; und
einer zweiten thermisch und elektrisch leitenden Schicht (103), die auf einer der Auflagefläche (113) gegenüberliegenden Sensorfläche (107) der ersten Substratschicht (101) angeordnet ist und ein mit der Sensorfläche (107) verbundenes Sensorelement (105) aufweist, das eingerichtet ist, eine Temperatur des stiftförmigen elektrischen Kontaktelements (200) zu erfassen, wobei
die Auflagefläche (113) der flexiblen Leiterplatte flächig an dem Flansch (201) des stiftförmigen elektrischen Kontaktelements (200) aufliegt,
**dadurch gekennzeichnet, dass** die Anordnung (300) ein Gehäuse mit einem ersten Gehäuseteil (301) und einem zweiten Gehäuseteil (303) umfasst,
wobei der Flansch (201) des stiftförmigen elektrischen Kontaktelements (200) an dem ersten Gehäuseteil (301) anliegt und wobei das zweite Gehäuseteil (303) eine Kraft auf die flexible Leiterplatte in Richtung des ersten Gehäuseteils (301) ausübt und die Auflagefläche (113) der flexiblen Leiterplatte so gegen den Flansch (201) des stiftförmigen elektrischen Kontaktelements (200) drückt, wobei zwischen der flexiblen Leiterplatte und dem zweiten Gehäuseteil (303) ein elastisches Anpresselement (205) angeordnet ist und wobei der Druck über das elastische Anpresselement (205) auf die flexible Leiterplatte ausgeübt wird, wobei zwischen dem Flansch (200) des stiftförmigen elektrischen Kontaktelements (200) und dem ersten Gehäuseteil (301) ein weiteres elastisches Anpresselement (305) angeordnet ist.

## Claims

1. An arrangement (300) having a pin-shaped contact element (200) and a temperature measuring device (100) for measuring a temperature of the pin-shaped electrical contact element (200), the temperature measuring device (100) comprising a flexible printed circuit board having
a first thermally conductive and electrically insulating substrate layer (101) with a contact surface (113) which is arranged to rest flat against a flange (201) of the pin-shaped electrical contact element (200), and
an opening (111) arranged in the contact surface (113), wherein the pin-shaped contact element (200) is arranged at least partially in the opening (111); and
a second thermally and electrically conductive layer (103), which is arranged on a sensor surface (107) of the first substrate layer (101) opposite the contact surface (113) and has a sensor element (105) which is connected to the sensor surface (107) and is set up to detect a temperature of the pin-shaped electrical contact element (200), the contact surface (113) of the flexible printed circuit board resting flat against the flange (201) of the pin-shaped electrical contact element (200), **characterized in that** the arrangement (300) includes
a housing with a first housing part (301) and a second housing part (303), wherein the flange (201) of the pin-shaped electrical contact element (200) bears against the first housing part (301) and wherein the second housing part (303) exerts a force on the flexible printed circuit board in the direction of the first housing part (301) and thus presses the contact surface (113) of the flexible printed circuit board against the flange (201) of the pin-shaped electrical contact element (200), wherein an elastic contact pressure element (205) is arranged between the flexible printed circuit board and the second housing part (303) and wherein the pressure is exerted on the flexible printed circuit board via the elastic contact pressure element (205), wherein a further elastic contact pressure element (305) is arranged between the flange (200) of the pin-shaped electrical contact element (200) and the first housing part (301).

## Revendications

1. Ensemble (300) comprenant un élément de contact électrique en forme de broche (200) et un dispositif de mesure de la température (100) pour mesurer une température de l'élément de contact électrique en forme de broche (200), le dispositif de mesure de la température (100) comprenant une carte de circuit imprimé flexible comportant
une première couche de substrat (101) thermiquement conductrice et électriquement isolante, comprenant
une surface d'appui (113) qui est conçue pour reposer à plat sur une bride (201) de l'élément de contact électrique (200) en forme de broche et
une ouverture (111) disposée dans la surface d'appui (113), l'élément de contact en forme de broche (200) étant disposé au moins partiellement dans l'ouverture (111) ; et
une deuxième couche (103) thermiquement et électriquement conductrice, qui est disposée sur une surface de capteur (107), opposée à la surface d'appui (113), de la première couche de substrat (101) et qui présente un élément de capteur (105) relié à la surface de capteur (107), qui est conçu pour détecter une température de l'élément de contact électrique (200) en forme de broche, la surface d'appui (113) de la carte imprimée flexible reposant à plat sur la bride (201) de l'élément de contact électrique en forme de broche (200), **caractérisé en ce que** l'agencement (300) est conçu de manière à ce que la surface d'appui (113) de la carte imprimée flexible soit en contact avec la surface de capteur (105).
un boîtier avec une première partie de boîtier (301) et une deuxième partie de boîtier (303), dans lequel la bride (201) de l'élément de contact électrique en forme de broche (200) repose sur la première partie de boîtier (301) et dans lequel la deuxième partie de boîtier (303) exerce une force sur la carte de circuit imprimé flexible en direction de la première partie de boîtier (301) et presse ainsi la surface d'appui (113) de la carte de circuit imprimé flexible contre la bride (201) de l'élément de contact électrique en forme de broche (200), un élément de pression élastique (205) étant disposé entre la carte de circuit imprimé flexible et la deuxième partie de boîtier (303) et la pression étant exercée sur la carte de circuit imprimé flexible par l'intermédiaire de l'élément de pression élastique (205), un autre élément de pression élastique (305) étant disposé entre la bride (200) de l'élément de contact électrique en forme de broche (200) et la première partie de boîtier (301).
